Europäisches Patentamt

European Patent Office

Office européen des brevets

(11) Veröffentlichungsnummer: **0 211 057**
**B1**

(12) **EUROPÄISCHE PATENTSCHRIFT**

(45) Veröffentlichungstag der Patentschrift: **31.10.90**

(51) Int. Cl.⁵: **C 23 C 14/34,** H 01 J 37/34

(21) Anmeldenummer: **86901066.0**

(22) Anmeldetag: **31.01.86**

(86) Internationale Anmeldenummer:
**PCT/EP86/00045**

(87) Internationale Veröffentlichungsnummer:
**WO 86/04616 14.08.86 Gazette 86/18**

(54) **SPUTTERANLAGE ZUM REAKTIVEN BESCHICHTEN EINES SUBSTRATES MIT HARTSTOFFEN.**

(30) Priorität: **01.02.85 DE 3503398**

(43) Veröffentlichungstag der Anmeldung:
**25.02.87 Patentblatt 87/09**

(45) Bekanntmachung des Hinweises auf die
Patenterteilung:
**31.10.90 Patentblatt 90/44**

(84) Benannte Vertragsstaaten:
**AT BE CH DE FR GB IT LI LU NL SE**

(56) Entgegenhaltungen:
**DE-A-1 515 294**
**GB-A-2 096 177**
**US-A-4 038 171**
**US-A-4 389 299**
**US-A-4 417 968**

(73) Patentinhaber: **LEYBOLD
AKTIENGESELLSCHAFT
Wilhelm-Rohn-Strasse 25
D-6450 Hanau am Main 1 (DE)**

(72) Erfinder: **HERKLOTZ, Günther
Thomas-Mann-Str. 18
D-6454 Bruchköbel (DE)**
Erfinder: **ELIGEHAUSEN, Hans
Hausmannstr. 22
D-6450 Hanau (DE)**

(74) Vertreter: **Zapfe, Hans, Dipl.-Ing.
Am Eichwald 7
D-6056 Heusenstamm 2 Rembrücken (DE)**

Courier Press, Leamington Spa, England.

## Beschreibung

### Stand der Technik

Die Erfindung betrifft eine Sputteranlage zum reaktiven Beschichten von Substraten mit Hartstoffen, insbesondere mit Ti-Nitrid oder Ti-Karbid, die ein evakuierbares, geerdetes Gehäuse mit einer Zuleitung für ein Reaktionsgas und ein Edelgas aufweist, und in dem die Sputter-Oberfläche eines als Sputter-Einheit dienenden Magnetrons sowie mindestens eine Halterung für die Substrate angeordnet sind, wobei die Substrate mittels der Halterung vor der Sputter-Oberfläche positionierbar sind.

Derartige Sputteranlagen, in denen eine sogenannte Hochleistungskatodenzerstäubung durchgeführt wird, sind beispielsweise aus dem Sonderdruck 11-S01 "Herstellung von harten Titan-Nitrid-Schichten mittels Hochleistungskatodenzerstäubung" (ebenfalls veröffentlicht in "Werkstoffe und ihre Veredlung", Heft 3, 1981, von W. D. Münz und G. Heßberger) der Leybold-Heraeus GmbH sowie durch die DE-OS 31 07 914 bekannt. Dort sind auch der prinzipielle Aufbau und die Wirkungsweise einer Magnetronkatode, kurz eines "Magnetrons" beschrieben.

Mit derartigen Sputteranlagen werden insbesondere Werkzeuge für die Zerspanungstechnik, beispielsweise Bohrer und Fräser, sowie Werkzeugformteile mit verschleißhemmenden Hartstoffschichten überzogen, um dadurch die Standzeiten der Werkzeuge gegenüber einem unbeschichteten Werkzeug zu erhöhen. Die Hochleistungskatodenzerstäubung zeichnet sich dadurch aus, daß eine hohe Zerstäubungs- und Niederschlagsrate eingestellt werden kann und daß darüberhinaus die Prozeßparameter genau und reproduzierbar eingehalten werden können. Bei einer Relativbewegung zwischen dem Substrat und der Magnetronkatode können auch große Flächen gleichmäßig beschichtet werden. Die Qualität der beschichteten Substrate ist von Parametern wie Substratvorspannung, Substratstrom, Arbeitsdruck, Arbeitstemperatur, von den geometrischen Verhältnissen der Sputteranlage sowie von der Feldstärke des Magnetfeldes und seiner Ausbildung abhängig.

Bei der bekannten Lösung geschieht die Substratbeschichtung durch zwei symmetrisch angeordnete Magnetronkatoden, zwischen denen die Substrate mittels einer rotierenden Substrathaltevorrichtung, eines sogenannten "Käfigs" kontinuierlich hindurchbewegt werden, ohne daß sie hierbei eine zusätzliche Rotationsbewegung gegenüber dem Käfig ausführen müßten.

Die bekannte Lösung bedarf einer sorgfältigen Einstellung aller Einflußgrößen und macht aufwendige Umstellungsarbeiten erforderlich, falls nacheinander Substrate unterschiedlicher Abmessungen, insbesondere Querabmessungen, beschichtet werden sollen. So ist es beispielsweise nicht ohne weiteres möglich, schlanke Bohrer und ausladende Messerköpfe in ein und derselben Charge zu beschichten. Aber auch die Vergrößerung des lichten Abstandes zwischen den beiden Magnetronkatoden für den Durchgang breiterer Substrate ist nicht bzw. nicht ohne weiteres möglich. Gerade in kleineren Produktionsbetrieben ist es aber häufig notwendig, Chargen zu beschichten, die aus unterschiedlichen Substraten bestehen. Bei mangelnder Anpassung zwischen den Magnetronkatoden und den Substraten ist jedoch die Qualität der Beschichtung nicht für alle Substratabmessungen gewährleistet.

Durch die US-A-4 389 299 ist eine Sputteranlage bekannt, die hinsichtlich der rein konstruktiven Ausführung, allerdings mit Ausnahme der Zuleitung für ein Reaktionsgas, der Sputteranlage nach dem Oberbegriff des Patentanspruchs 1 entspricht.

### Aufgabe

Gegenüber dem eingangs beschriebenen Stand der Technik, der sich auf Sputteranlagen für die reaktive Katodenzerstäubung bezieht, liegt der Erfindung die Aufgabe zugrunde, eine Sputteranlage der eingangs beschriebenen Art zu schaffen, die ohne eine komplizierte Neueinstellung der wesentlichen Verfahrensparameter auch die Beschichtung von Substraten unterschiedlicher Größe erlaubt, so daß bei allen Substraten eine wesentliche Erhöhung der Gebrauchsdauer eintritt.

### Erfindung

Die Lösung der gestellten Aufgabe erfolgt bei der eingangs angegebenen Sputteranlage erfindungsgemäß dadurch, daß

a) die Halterung für die Substrate zwischen einer Ionisationseinrichtung mit wenigstens zwei Elektroden angeordnet ist, von denen die eine Elektrode als Elektronen-Emitter betreibbar ist und die andere Elektrode gegenüber der Emitter-Elektrode eine Anode ist und wobei die Substrathalterung selbst an einem gegenüber Masse negativen Pol einer Spannungsquelle liegt,

b) die mindestens eine Anode auf der dem Magneton zugekehrten Seite der Substrat-Halterung liegt und dem Magnetron unmittelbar benachbart ist,

c) die mindestens eine Emitter-Elektrode auf der dem Magnetron abgekehrten Seite der Substrathalterung liegt und daß

d) in dem Gehäuse mindestens ein die Bahn der von der Emitter-Elektrode ausgehenden Elektronen verlängerndes Magnetsystem angeordnet ist.

### Vorteile

Bei der erfindungsgemäßen Sputteranlage wird durch gezielten Elektroneneinschuß die Plasmadichte wesentich erhöht. Dabei sind Substratströme erreichbar, die oberhalb von 5 mA/cm² liegen. Mit solchen Bias-Strömen werden nahezu strukturlose Schichten und bessere Haftfestigkeiten erreicht, und zwar auch dann, wenn die einzelnen Flächenelemente der Substrate unterschiedliche Abstände von der Sputter-Oberfläche haben. Die Sputter-Rate verringert sich hierbei nicht. Durch das die Elektronenbahnen verlängernde Magnetsystem wird eine zusätzliche Erhöhung des Bias-Stromes um etwa 30% erreicht.

Es ist dabei besonders vorteilhaft, wenn das Magnetsystem in einem Bereich gegenüber der Sputter-Oberfläche des Magnetrons, und das Substrat und die Elektroden zwischen der Sputter-Oberfläche und dem Magnetsystem angeordnet sind.

Das Magnetsystem besteht dabei in besonders vorteilhafter Weise aus ineinanderliegenden Magneten jeweils entgegengesetzter Polungsrichtung, derart, daß von den Magneten ein in sich geschlossener Tunnel aus bogenförmigen magnetischen Feldlinien ausgeht. Das Magnetsystem ähnelt infolgedessen solchen Magnetsystemen, wie sie bei den Magnetronkatoden angewandt werden. Es besitzt jedoch keine Quelle für das Beschichtungsmaterial, d.h. kein sogenanntes Target.

Weitere Vorteile und Einzelheiten der erfindungsgemäßen Sputteranlage ergeben sich aus der nachfolgenden Beschreibung zweier Ausführungsbeispiele.

Figurenbeschreibung
Es zeigen:
Figur 1 einen Vertikalschnitt durch eine schematisch dargestellte vollständige Sputteranlage,
Figur 2 eine perspektivische Ansicht eines Teils einer Variante von Figur 1 mit zwei innenliegenden Magnetrons, denen paarweise jeweils zwei positive Elektroden unmittelbar zugeordnet sind,
Figur 3 eine perspektivische Darstellung der dem Magnetrons nach Figur 2 jeweils unmittelbar gegenüberliegend angeordneten Emitter-Elektroden (links), bzw. des hinter den Emitter-Elektroden angeordneten Kastens mit dem Magnetsystem (rechts) und
Figur 4 einen Horizontalschnitt durch Figur 3 entlang der Linie IV-IV in vergrößertem Maßstab.

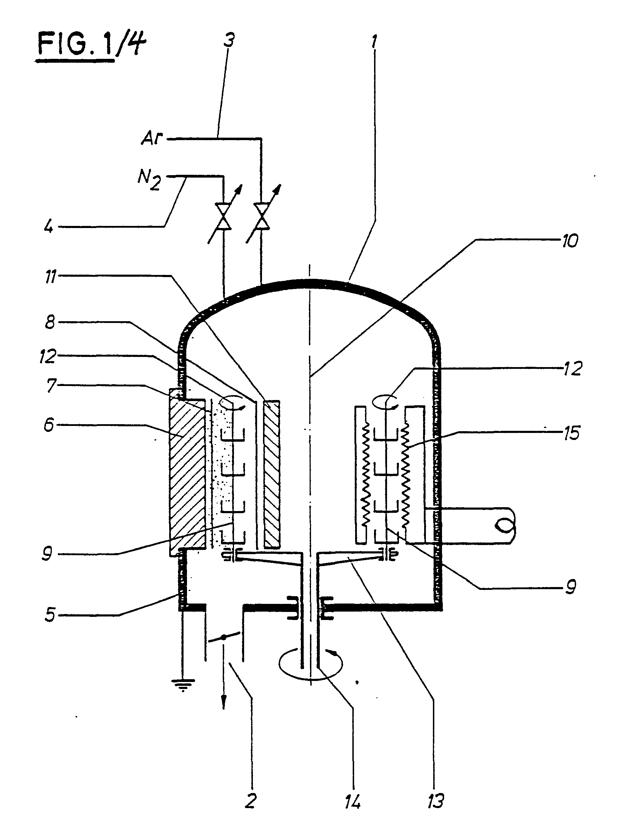

Detailbeschreibung
Die Sputteranlage nach Figur 1 besitzt ein vakuumdichtes, geerdetes Gehäuse 1, das über einen im Bodenbereich befindlichen Anschlußstutzen 2 evakuierbar ist. Über die Zuleitungen 3 und 4 im Deckenbereich des Gehäuses 1 kann wahlweise ein Inertgas, beispielsweise Argon, und/oder ein Reaktionsgas, beispielsweise Stickstoff, in das Gehäuse 1 eingeleitet werden. In die seitliche Gehäusewandung 5 ist ein Magnetron 6 (eine sogenannte Hochleistungs-Zerstäubungskatode) eingesetzt, auf die beispielsweise polykristallines Ti-Metall als Target aufgebondet ist.

In unmittelbarer Nachbarschaft des Magnetrons 6 ist in dem Gehäuse 1 eine Ionisationseinrichtung mit zwei Elektroden 7 und 8 angeordnet, zwischen denen auf einer kreisförmigen Bahn eine Substrathalterung 9 hindurchführbar ist, an der die nicht gezeigten Substrate befestigt sind.

Von den beiden Elektroden 7 und 8 der Ionisationseinrichtung liegt die dem Magnetron 6 näher liegende Elektrode 7 an positiver Spannung, während die dem Magnetron abgewandte Elektrode die Emitter-Elektrode 8 ist. Bei den Elektroden handelt es sich bevorzugt jeweils um einen oder zwei Stäbe aus einem temperaturbeständigen Metall wie Wolfram. Hinter der Emitter-Elektrode 8 ist (in Blickrichtung vom Magnetron 6 zur Gehäuseachse 10) ein Magnetsystem 11 angeordnet, das die weiter oben beschriebene Erhöhung des Bias-Stromes um bis zu 30% bewirkt.

Die Substrathalterungen 9 sind um je eine Achse 12 drehbar gelagert, so daß eine allseitige und gleichmäßige Beschichtung der Substrate im Bereich der Ionisationseinrichtung und des Magnetrons erfolgen kann. Eine ganze Anzahl solcher Substrathalterungen 9 sind an einer horizontalen Trageinrichtung 13 befestigt, die mittels einer hierzu koaxialen Antriebswelle 14 um die Gehäuseachse 10 drehbar ist.

In dem der Ionisationseinrichtung gegenüberliegenden Gehäusebereich ist eine Heizstation 15 angeordnet, an der die Substrat-Halterungen 9 mit den Substraten beim Rotieren der Trageinrichtung 13 um die Gehäuseachse 10 vorbeigeführt werden, um sie vor der Beschichtung aufzuheizen.

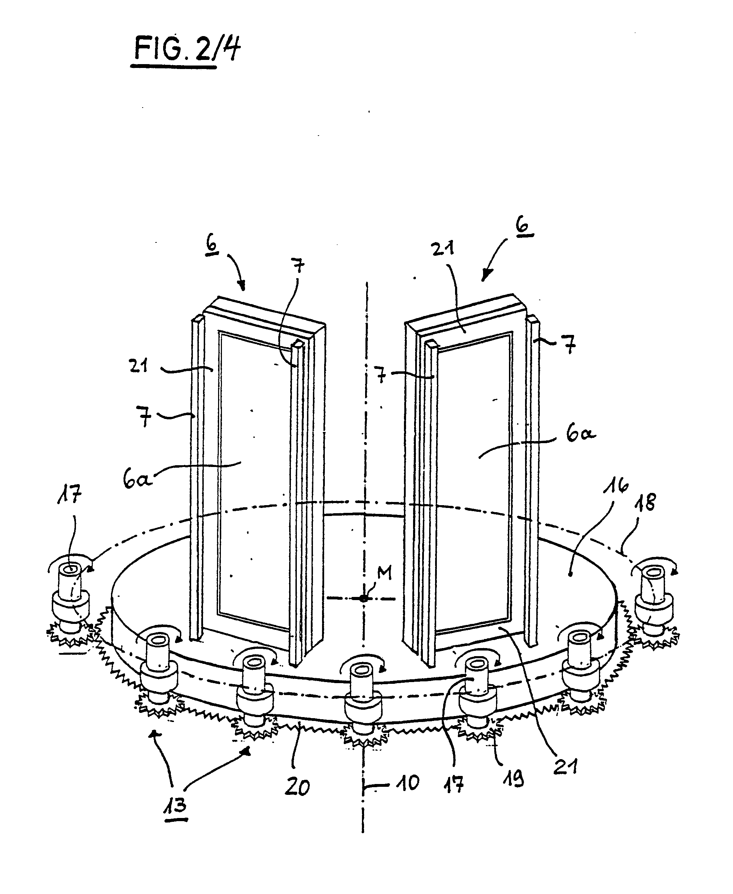

Figur 2 zeigt (im Vergleich zur Blickrichtung in Figur 1) die umgekehrte Bauweise, d.h. zwei Magnetrons 6 sind im Innern des hier nicht gezeigten Gehäuses 1 angeordnet, und zwar in der Weise, daß eine Normale durch den Mittelpunkt einer jeden Sputter-Oberfläche 6a in radialer Richtung zur Gehäuseachse 10 verläuft.

Die beiden Magnetrons 6 sind — isoliert — auf einer kreisförmigen, stationären Tragplatte 16 angeordnet. Um die durch deren Mittelpunkt M gehende Gehäuseachse 10 rotiert die Trageinrichtung 13, zu der ein hier nicht gezeigter angetriebener Ring gehört, an dem eine Anzahl von Drehlagerungen 17 befestigt sind, deren Drehachsen eine Umlaufbewegung entlang der strichpunktierten Bewegungsbahn 18 ausführen, die eine Kreisbahn mit dem Mittelpunkt M ist. Zum Antrieb der Drehlagerungen 17 besitzen diese an ihrem unteren Ende je ein Zahnrad 19, das sich auf einer ringförmigen Zahnleiste 20 abwälzt, die stationär an der Tragplatte 16 befestigt ist. Hierdurch führen die Drehlagerungen 17 eine zusammengesetzte Bewegung aus, nämlich eine Kreisbewegung um den Mittelpunkt M und eine Drehbewegung um ihre eigene Drehachse in Richtung der eingezeichneten Pfeile. In jede der Drehlagerungen 17 ist eine Substrat-Halterung 9 gemäß Figur 1 einsteckbar, so daß die daran befestigten Substrate vor den Sputter-Oberflächen 6a der Magnetrons 6 vorbeigeführt werden und durch ihre zusätzliche Eigendrehung allseitig beschichtet werden.

Es ist hier dargestellt, daß die Magnetrons 6 auf ihrem Umfang von je einem Rahmen 21 aus einem magnetisierbaren Werkstoff (beispielsweise Eisen) umgeben sind. Durch diese Maßnahme werden Spannungsüberschläge verhindert, die beim Betrieb gelegentlich auftreten können.

Es ist weiterhin zu erkennen, daß die Magnetrons 6 je eine rechteckige Sputter-Oberfläche 6a aufweisen, und daß die paarweise vorhandenen positiven Elektroden 7 beiderseits der Magnetrons 6 und jeweils in unmittelbarer Nähe der beiden längsten Kanten der Sputter-Oberfläche angeordnet sind. Die Elektroden 7 können sich dabei auf Massepotential befinden, sie können aber auch auf einem gegenüber Masse noch weiter positiven Potential liegen.

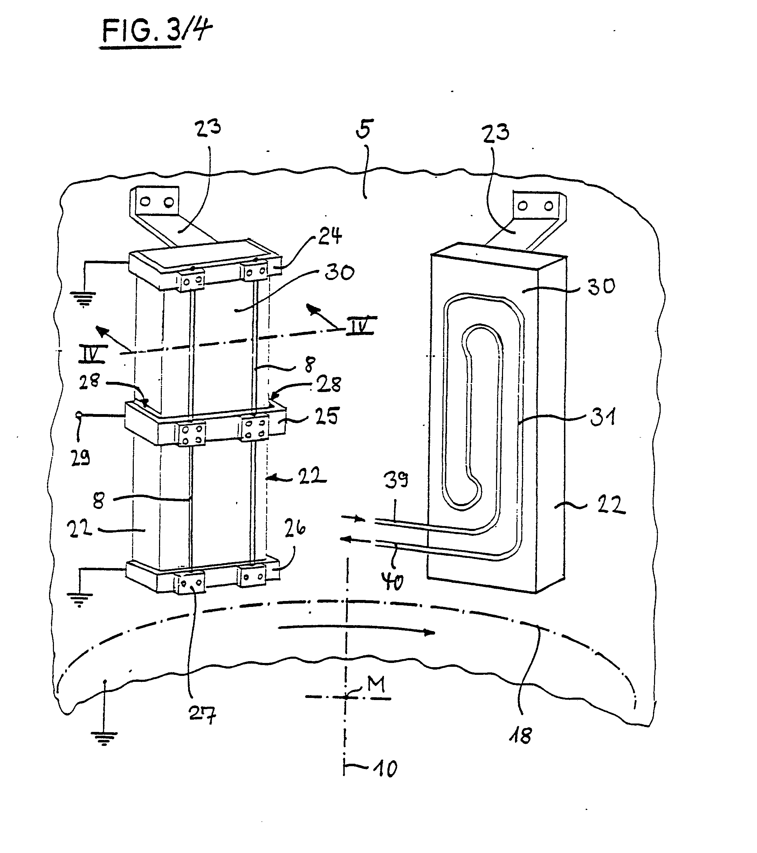

In Figur 3 ist die gleiche Bewegungsbahn 18 wie in Figur 2 in einem Ausschnitt dargestellt. Die Blickrichtung ist hier genau entgegengesetzt, d.h. vom Mittelpunkt M bzw: von der Gehäuseachse 10 nach außen. Zu erkennen ist die Gehäusewandung 5, an der zwei quaderförmige Kästen 22 über Streben 23 befestigt sind. In Figur 3 — links — ist die Anordnung fertig montiert, und zwar sind auf dem Kasten 22 zwei Emitter-Elektroden 8 befestigt, die aus geraden Wolfram-Stäben bestehen. Es ist erkennbar, daß sich diese Emitter-Elektroden 8 außerhalb der Bewegungsbahn 18 befinden, und zwar in genauer Gegenüberlage zu den Magnetrons 6 (Figur 2). Die Substrat-Halterungen 9 müssen also auf ihrem Wege zwischen den Magnetrons 6 und den positiven Elektroden 7 einerseits und den Emitter-Elektroden 8 andererseits hindurchlaufen.

Aus einer Zusammenschau der Figuren 2 und 3 ergibt sich außerdem, daß jede der Emitter-Elektroden 8 parallel zu jeder der positiven Elektroden 7 verläuft, und daß die betreffenden Elektroden innerhalb einer diese schneidenden, zur Gehäuseachse 10 radialen Ebene an den Ecken eines Vierecks liegen, wobei jeweils zwei Ecken beiderseits der Bewegungsbahn 18 für die Substrathalterung 9 liegen.

Zum Zwecke einer Befestigung der Emitter-Elektroden 8 besitzt der Kasten 22 drei Kontakteinrichtungen 24, 25 und 26 in Form von U-förmigen Bügeln mit Klemmenplatten 27. Die Kontakteinrichtungen 24 und 26 an den Enden des Kastens 22 sind mit diesem elektrisch leitend verbunden und liegen infolgedessen auf Massepotential. Die mittlere Kontakteinrichtung 25 ist jedoch über Isolierkörper 28 an dem Kasten 22 befestigt, so daß die Emitter-Elektroden 8 in ihrer Mitte über eine Anschlußklemme 29 an eine Heizspannung von wenigen Volt gelegt werden können, so daß sie auf eine ausreichend hohe Emissionstemperatur aufgeheizt werden können.

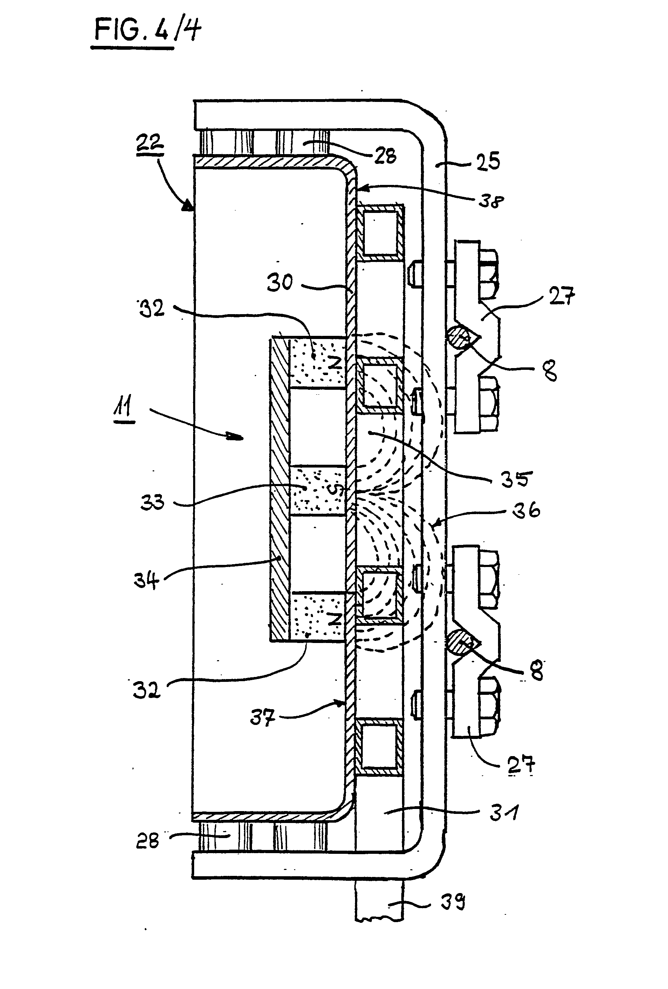

Aus Figur 3 ist noch zu entnehmen, daß die Frontseiten der Kästen 22 durch eine ebene Platte 30 gebildet werden. Diese Platte ist mit einer Kühleinrichtung 31 versehen, deren Verlauf in Figur 3 — rechts — dargestellt ist. Sie wurde der Übersichtlichkeit halber im linken Teil von Figur 3 zeichnerisch nicht dargestellt. Auch wurden auf der rechten Seite von Figur 3 die in Wirklichkeit vorhandenen Emitter-Elektroden 8 mit ihren Kontakteinrichtungen 24, 25 und 26 der Anschaulichkeit halber fortgelassen. Wie aus Figur 4 erkennbar ist, befindet sich in dem quaderförmigen Kasten 22 hinter dessen Platte 30 ein Magnetsystem 11, das aus ineinanderliegenden Magneten 32 und 33 besteht. Bei dem Magneten 33 handelt es sich um eine lineare Anordnung mehrerer Permanentmagnete mit der gleichen, eingezeichneten, Pollage. Die Magnete 33 werden von zwei parallelen Reihen von Magneten 32 mit entgegengesetzter aber untereinander jeweils gleicher Pollage begleitet. Die äußeren Magnete 32 sind an ihren Enden durch Magnete wiederum gleicher Pollage verbunden, so daß ein äußerer magnetischer Rahmen gebildet wird, der die Reihe der inneren Magnete 33 allseitig mit Abstand umgibt. Die der Platte 30 abgekehrte Seite sämtlicher Magnete ist durch eine Polplatte 34 abgedeckt, deren Kontur mit der äußeren Kontur des Rahmens aus den Magneten 32 kongruent ist. Durch diese magnetische Anordnung sowie durch die Tatsache, daß die Platte 30 aus einem amagnetischen Werkstoff besteht, wird ein allseits geschlossener Tunnel 35 aus magnetischen Feldlinien 36 gebildet, durch die die von den Emitter-Elektroden 8 ausgesandten Elektronen auf einer verlängerten (schraubenlinienförmigen) Bahn geführt werden.

Wie aus Figur 4 ersichtlich ist, befindet sich das Magnetsystem 11 auf der Rückseite 37 der Platte 30, so daß sich der Tunnel 35 auf der Vorderseite 38 ausbildet. Auf dieser Vorderseite befindet sich auch die Kühleinrichtung 31 in Form eines mäanderförmig verlegten Vierkantrohres mit Anschlußenden 39 und 40.

Der Verlauf des magnetischen Tunnels 35 entspricht dem Verlauf des Hohlraums zwischen den Magneten 32 und 33. Daraus ergibt sich, daß die beiden Emitter-Elektroden 8 in der in Figur 4 gezeigten Anordnung in unmittelbarer Nähe des Tunnels und parallel zur Platte 30 auf deren Vorderseite verlaufen.

**Patentansprüche**

1. Sputteranlage zum reaktiven Beschichten von Substraten mit Hartstoffen, insbesondere mit Ti-Nitrid oder Ti-Karbid, die ein evakuierbares geerdetes Gehäuse (1) mit einer Zuleitung (4; 3) für ein Reaktionsgas und ein Edelgas aufweist, und in dem die Sputter-Oberfläche eines als Sputter-Einheit dienenden Magnetrons (6) sowie mindestens eine Halterung (9) für die Substrate angeordnet sind, wobei die Substrate mittels der Halterung (9) vor der Sputter-Oberfläche positionierbar sind, dadurch gekennzeichnet, daß

a) die Halterung (9) für die Substrate zwischen einer Ionisationseinrichtung mit wenigstens zwei Elektroden (7, 8) angeordnet ist, von denen die eine Elektrode (8) als Elektronen-Emitter betreibbar ist und die andere Elektrode gegenüber der Emitter-Elektrode (8) eine Anode (7) ist und wobei die Substrat-Halterung (9) selbst an einem gegenüber Masse negativen Pol einer Spannungsquelle liegt,

b) die mindestens eine Anode (7) auf der dem Magnetron (6) zugekehrten Seite der Substrat-Halterung (9) liegt und dem Magnetron (6) unmittelbar benachbart ist,

c) die mindestens eine Emitter-Elektrode (8) auf der dem Magnetron (6) abgekehrten Seite der Substrathalterung (9) liegt, und daß

d) in dem Gehäuse (1) mindestens ein die Bahn der von der Emitter-Elektrode (8) ausgehenden Elektronen verlängerndes Magnetsystem (11) angeordnet ist.

2. Sputteranlage nach Anspruch 1, dadurch gekennzeichnet, daß das Magnetsystem (11) gegenüber der Sputter-Oberfläche des Magnetrons (6) und das Substrat (9) und die Elektroden (7, 8) zwischen der Sputter-Oberfläche und dem Magnetsystem (11) angeordnet sind.

3. Sputteranlage nach Anspruch 2, dadurch gekennzeichnet, daß das Magnetsystem (11) aus ineinanderliegenden Magneten jeweils entgegengesetzter Polungsrichtung besteht, derart, daß von den Magneten ein in sich geschlossener Tunnel (35) aus bogenförmigen magnetischen Feldlinien (36) ausgeht.

4. Sputteranlage nach Anspruch 3, dadurch gekennzeichnet, daß das Magnetsystem (11) auf der Rückseite (37) einer aus amagnetischem Werkstoff bestehenden Platte (30) angeordnet ist, derart, daß sich der Tunnel (35) auf der Vorderseite (38) der Platte (30) befindet, und daß die mindestens eine Emitter-Elektrode (8) in unmittelbarer Nähe des Tunnels und parallel zur Platte (30) auf deren Vorderseite verläuft.

5. Sputteranlage nach Anspruch 1, dadurch gekennzeichnet, daß bei einem Magnetron (6) mit einer rechteckigen Sputter-Oberfläche die Anode (7) aus einem Elektrodenpaar besteht, das beiderseits des Magnetrons (6) und jeweils in unmittelbarer Nähe der beiden längsten Kanten der Sputter-Oberfläche angeordnet ist.

6. Sputteranlage nach Anspruch 5, dadurch gekennzeichnet, daß bei einem Magnetron (6) mit einer rechteckigen Sputter-Oberfläche die Emitter-Elektrode (8) aus einem Elektrodenpaar besteht, von denen jede Elektrode (8) parallel zu jeder der Anoden (7) verläuft.

7. Sputteranlage nach Anspruch 6, dadurch gekennzeichnet, daß die Elektroden (7, 8) innerhalb einer diese schneidenden, zur Gehäuseachse (10) radialen Ebene an den Ecken eines Vierecks liegen, wobei jeweils zwei Ecken beiderseits einer Bewegungsbahn (18) für die Substrathalterung (9) liegen.

8. Sputteranlage nach Anspruch 1, dadurch gekennzeichnet, daß bei einem Magnetron (6) mit rechteckiger Sputter-Oberfläche der magnetische Tunnel (35) zwei parallele Längsseiten aufweist, zu denen die Emitter-Elektroden (8) parallel verlaufen.

9. Sputteranlage nach Anspruch 8, dadurch gekennzeichnet, daß die Platte (30) die Frontseite eines quaderförmigen Kastens (22) ist, an dessen Enden die Enden der Emitter-Elektroden (8) elektrisch leitend befestigt sind und in dessen Mitte isoliert eine Kontakteinrichtung (25) befestigt ist, über die den Emitter-Elektroden (8) eine Heizspannung zuführbar ist.

10. Sputteranlage nach Anspruch 9, dadurch gekennzeichnet, daß die Platte (30) mit einer Kühleinrichtung (31) versehen ist.

11. Sputteranlage nach Anspruch 1, dadurch gekennzeichnet, daß das Magnetron (6) auf seinem Umfang von einem Rahmen (21) aus einem magnetisierbarem Werkstoff umgeben ist.

**Revendications**

1. Installation de pulvérisation pour revêtement réactif de substrats avec des matières dures, notamment avec du nitrate de Ti ou du carbure de Ti, dotée d'une enceinte (1) reliée à la terre, pouvant être mise sous vide, avec une conduite d'amenée (4; 3) pour un gaz de réaction et un gaz inerte, et dans laquelle sont disposées la surface de pulvérisation d'un magnétron (6) servant d'unité de pulvérisation ainsi qu'au moins une monture (9) pour les substrats, lesquels peuvent être positionnés devant la surface de pulvérisation, au moyen de la monture (9), caractérisée par le fait que

a) la monture (9) pour les substrats est agencée dans l'espace intermédiaire d'un dispositif d'ionisation ayant au moins deux électrodes (7, 8) dont la première (8) peut opérer en tant qu'émetteur d'électrons et l'autre constitue une anode (7) par rapport à l'électrode-émetteur (8), la monture (9) pour les substrats étant elle-même à un pôle d'une source de tension qui est négatif par rapport à la masse;

b) l'anode (7) au nombre d'au moins un se trouve sur le côté de la monture (9) pour les substrats qui est tourné vers le magnétron (6), et est à proximité immédiate du magnétron (6);

c) l'électrode-émetteur (8) au nombre d'au moins un se trouve sur le côté de la monture (9) pour les substrats qui n'est pas tourné vers le magnétron (6), et

d) au moins un système magnétique (11) allongeant la trajectoire des électrons provenant de l'électrode-émetteur (8) est agencé dans l'enceinte.

2. Installation de pulvérisation selon revendication 1, caractérisée par le fait que le système magnétique (11) est agencé en vis-à-vis de la surface de pulvérisation du magnétron (6) et le substrat (9) et les électrodes (7, 8) sont agencés entre la surface de pulvérisation et le système magnétique (11).

3. Installation de pulvérisation selon revendication 2, caractérisée par le fait que le système magnétique (11) est constitué par des aimants interjacents ayant à chaque fois une direction polaire opposée, de manière qu'un tunnel fermé en soi (35), fait de lignes de champ magnétique en forme d'arc (36) parte des aimants.

4. Installation de pulvérisation selon revendication 3, caractérisée par le fait que le système magnétique (11) est agencé sur le côté arrière (37) d'une plaque (30) faite en matière amagnétique, de manière que le tunnel (35) se trouve sur le côté avant (38) de la plaque (30), et par le fait que l'électrode-émetteur (8) au nombre d'au mòins un suit un tracé à proximité immédiate du tunnel et parallèlement à la plaque (30), sur le côté avant de celle-ci.

5. Installation de pulvérisation selon revendication 1, caractérisée par le fait que, dans le cas d'un magnétron (6) avec surface de pulvérisation rectangulaire, l'anode (7) consiste en une paire d'électrodes qui est agencée des deux côtés du magnétron (6), à chaque fois à proximité immédiate des deux bords longitudinaux de la surface de pulvérisation.

6. Installation de pulvérisation selon revendication 5, caractérisée par le fait que, dans le cas d'un magnétron (6) avec une surface de pulvérisation rectangulaire, l'électrode-émetteur (8) est constituée par une paire d'électrodes dont chaque électrode (8) suit un tracé parallèle à celui des anodes (7).

7. Installation de pulvérisation selon revendication 6, caractérisée par le fait que les électrodes (7, 8) sont situées à l'intérieur d'un plan qui les coupe et qui est radial par rapport à l'axe (10) de l'enceinte, aux coins d'un rectangle, deux coins se trouvant à chaque fois de part et d'autre d'une trajectoire (18) de la monture (9) pour les substrats.

8. Installation de pulvérisation selon revendication 1, caractérisée par le fait que, dans le cas d'un magnétron (6) ayant une surface de pulvérisation rectangulaire, le tunnel magnétique (35) présente deux côtés longitudinaux parallèles, par rapport auxquels les électrodes-émetteurs (8) suivent un tracé parallèle.

9. Installation de pulvérisation selon revendication 8, caractérisée par le fait que la plaque (30) est le côté frontal d'un caisson parallélipipèdique (22) aux extrémités duquel les électrodesémetteurs (8) sont fixées avec possibilité de conduction électrique et au milieu duquel un dispositif de contact (25) est fixé en étant isolé, a une tension de chauffage pouvant être amenée aux électrodes-émetteurs (8) via ce dispositif de contact.

10. Installation de pulvérisation selon revendication 9, caractérisée par le fait que la plaque (30) est munie d'un dispositif de refroidissement (31).

11. Installation de pulvérisation selon revendication 1, caractérisée par le fait que le magnétron (6) est entouré, sur son pourtour, par un cadre (21) en matière magnétisable.

## Claims

1. Sputtering installation for the reactive coating of substrates with hard materials, especially with titanium nitride or titanium carbide, which has an evacuable earthed housing (1) with feed lines (4, 3) for a reaction gas and an inert gas, and in which are disposed the sputtering surface of a magnetron (6) serving as sputtering unit and at least one mounting (9) for the substrates, the substrates being positionable by means of the mounting (9) before the sputtering surface, characterized in that

a) the mounting (9) for the substrates is disposed between an ionization device with at least two electrodes (7, 8), of which the one electrode (8) can be operated as an electron-emitter and the other electrode is an anode (7) in relation to the emitter electrode (8), the substrate mounting itself (9) being attached to a negative pôle relative to earth of a voltage source,

b) the at least one anode (7) is situated on the side of the substrate mounting (9) facing the magnetron (6) and immediately adjacent to the magnetron (6),

c) the at least one emitter electrode (8) is situated on the side of the substrate mounting (9) away from the magnetron (6), and that

d) in the housing (1) is disposed at least one magnet system (11) which extends the path of the electrons originating from the emitter electrode (8).

2. Sputtering installation according to Claim 1, characterized in that the magnet system (11) is disposed opposite the sputtering surface of the magnetron (6) and the substrate (9), and the electrodes (7, 8) are disposed between the sputtering surface and the magnet system (11).

3. Sputtering installation according to Claim 2, characterized in that the magnet system (11) consists of magnets placed together, each with opposed polarity direction, in such a way that a self-contained tunnel (35) of arch-shaped lines of magnetic flux (36) emanates from the magnets.

4. Sputtering installation according to Claim 3, characterized in that the magnet system (11) is disposed on the back (37) of a plate (30) of nonmagnetic material, in such a way that the tunnel (35) is situated on the front 38 of the plate (30), and that the at least one emitter electrode (8) runs in close proximity to the tunnel and parallel to the plate (30) in front of it.

5. Sputtering installation according to Claim 1, characterized in that with a magnetron (6) with a rectangular sputtering surface the anode (7) consists of a pair of electrodes which are disposed on either side of the magnetron (6) and each in close proximity to the two longest edges of the sputtering surface.

6. Sputtering installation according to Claim 5, characterized in that with a magnetron (6) with a rectangular sputtering surface the emitter electrode (8) consists of a pair of electrodes, each electrode of which (8) runs parallel to each of the anodes (7).

7. Sputtering installation according to Claim 6, characterized in that, within a plane radial to the housing axis (10) and intersecting the electrodes (7, 8), the electrodes (7, 8) are situated at the corners of a rectangle, two corners lying on each side of a path of travel (18) of the substrate mounting (9).

8. Sputtering installation according to Claim 1, characterized in that with a magnetron (6) with a rectangular sputtering surface the magnetic tunnel (35) has two parallel longitudinal sides, to which the emitter electrodes (8) run parallel.

9. Sputtering installation according to Claim 8, characterized in that the plate (30) is the front side of a box (22) having the shape of a cuboid, to the ends of which the ends of the emitter electrodes (8) are fixed and electrically connected and in the middle of which and insulated from it is fixed a contacting device (25), by which a heating voltage can be supplied to the emitter electrodes (8).

10. Sputtering installation according to Claim 9,

EP 0 211 057 B1

characterized in that the plate (30) is provided with a cooling device (31).

11. Sputtering installation according to Claim 1, characterized in that the magnetron (6) is surrounded on its periphery by a frame (21) of a magnetizable material.

**EP 0 211 057 B1**

FIG. 1/4

FIG. 2/4

# FIG. 3/4

FIG. 4/4